(19) Europäisches Patentamt / European Patent Office / Office européen des brevets

(11) **EP 3 832 430 B1**

(12) **FASCICULE DE BREVET EUROPEEN**

(45) Date de publication et mention
de la délivrance du brevet:
**19.03.2025 Bulletin 2025/12**

(21) Numéro de dépôt: **20211962.4**

(22) Date de dépôt: **04.12.2020**

(51) Classification Internationale des Brevets (IPC):
**G05F 3/24** *(2006.01)*  **H03K 3/03** *(2006.01)*
**G05F 3/26** *(2006.01)*

(52) Classification Coopérative des Brevets (CPC):
**G05F 3/24; G05F 3/262; H03K 3/0315**

(54) **CIRCUIT ELECTRONIQUE DE DIVISEUR DE TENSION EN TECHNOLOGIE FDSOI**

ELEKTRONISCHE SPANNUNGSTEILERSCHALTUNG IN FDSOI TECHNOLOGIE

ELECTRONIC VOLTAGE DIVIDER CIRCUIT IN FDSOI TECHNOLOGY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **06.12.2019 FR 1913861**

(43) Date de publication de la demande:
**09.06.2021 Bulletin 2021/23**

(73) Titulaire: **Commissariat à l'Energie Atomique et
aux Energies
Alternatives
75015 Paris (FR)**

(72) Inventeur: **QUELEN, Anthony
38054 GRENOBLE Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**US-A1- 2002 158 614      US-A1- 2014 077 864
US-A1- 2015 116 042      US-A1- 2016 352 339
US-A1- 2017 153 659**

**Description**

La présente invention concerne un circuit diviseur de tension comprenant des transistors sur couche mince isolante (ou de type FDSOI, ou « Fully Depleted Silicon On Insulator » en anglais), et pouvant être utilisés dans différents circuits, par exemple un circuit de génération d'horloge incluant un oscillateur en anneau.

Les oscillateurs en anneau comprennent un nombre impair d'inverseurs formant une boucle. En sortie de chaque inverseur, on obtient un signal oscillant naturellement. Leur fréquence d'oscillation est basée sur le temps de commutation des inverseurs, elle est donc directement liée au nombre d'inverseurs dans la boucle. Plus il y a d'inverseurs, plus la fréquence d'oscillation diminue. Le temps de commutation d'un inverseur dépend de différents paramètres, notamment leur tension d'alimentation, leur température, et ce temps de commutation peut varier d'un inverseur à un autre en raison des dispersions technologiques. La fréquence d'oscillation est donc fortement dépendante de ces paramètres et peut difficilement être contrôlée et stabilisée.

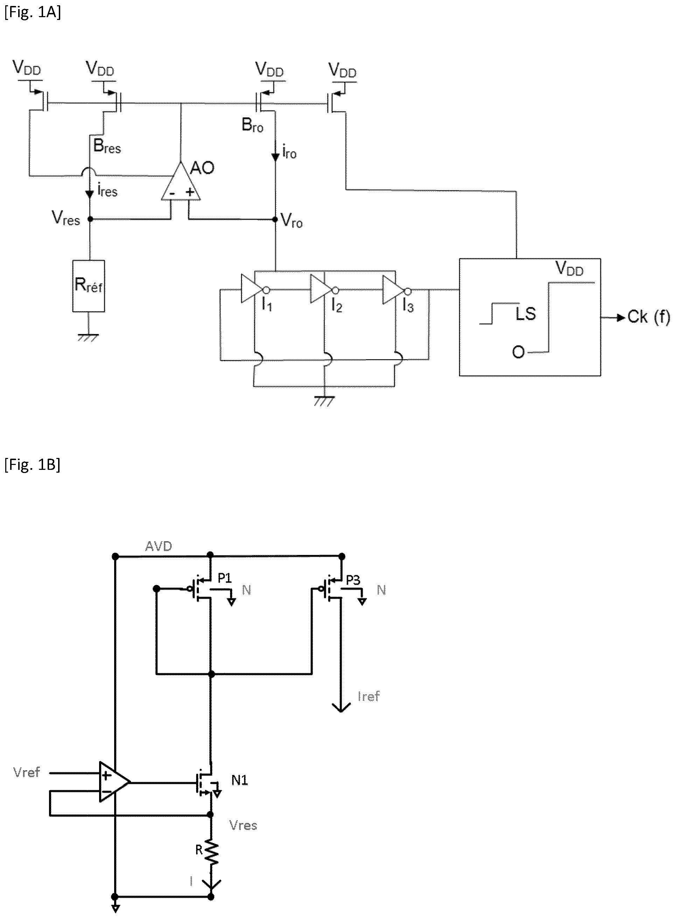

Afin de résoudre ce problème, on trouve dans l'art antérieur des oscillateurs en anneau comprenant un circuit de génération d'une alimentation en courant/tension comprenant un amplificateur différentiel AO et une résistance de référence $R_{réf}$, tel que présenté en figure 1A.

Le principe de fonctionnement de ce type d'oscillateur est d'asservir la résistance intrinsèque (venant des inverseurs I1, I2 et I3 qui peuvent être assimilées à des capacités qui commutent) de la chaîne d'inverseurs I1, I2, I3 par rapport à la résistance de référence $R_{réf}$. La résistance de référence $R_{réf}$ est fixe. La résistance intrinsèque est alors égale à la résistance de référence $R_{réf}$, car les potentiels $V_{ro}$ et $V_{res}$ sont identiques et les courants ires, $i_{ro}$ circulant dans les deux branches $B_{res}$ et $B_{ro}$ sont identiques.

Ce type d'oscillateur oscille à une fréquence f dépendant de la résistance intrinsèque, donc de la résistance de référence $R_{réf}$, d'une capacité équivalente C représentant la commutation des inverseurs I1, I2 et I3 et d'un paramètre n représentant le nombre d'inverseurs dans la boucle, telle que $f = 1 / (n \times C \times R_{réf})$.

Cependant, pour des oscillateurs à faible puissance, il est nécessaire d'utiliser une résistance de référence $R_{réf}$ de forte valeur (environ 10 à 100 MΩ), car les potentiels $V_{res}$ et $V_{ro}$ en entrée de l'amplificateur AO sont de quelques centaines de millivolts et les courants sont les plus faibles possibles pour des raisons de consommation. La résistance $R_{réf}$ est donc encombrante et coûteuse en terme de surface silicium. Par exemple, pour une tension $V_{ro} = V_{res} = 500$ mV et un courant i de 100 nA, il faudra utiliser une résistance $R_{réf}$ de 5 MΩ. La résistance $R_{réf}$ sera donc encombrante et représentera, en pratique, quasiment 80 % de la surface en silicium de l'oscillateur.

Cette architecture nécessite un compromis entre la fréquence d'oscillation, la puissance consommée et la surface en silicium de la résistance de référence $R_{réf}$ dans une application faible puissance (environ 10 à 50 nW).

Par ailleurs, un inconvénient du circuit oscillateur représenté en figure 1 est qu'il est difficile en pratique de le rendre insensible aux variations de température. Si la valeur de la résistance de référence varie en fonction de la température alors la fréquence de l'oscillateur va varier également. Ainsi, l'utilisation d'un tel oscillateur nécessite d'utiliser des résistances peu ou pas sensible à la température si on ne veut pas entraîner de variations de la fréquence d'oscillation. Ceci limite les possibilités de réalisation des résistances et peut entraîner un surcoût de surface pour réaliser de telles résistances insensibles aux variations de température. En outre, il est rarement possible d'avoir une résistance compensée en température, notamment dans les technologies FDSOI.

Plus généralement, ce problème d'encombrement de la surface silicium se pose également dans toutes les applications utilisant une résistance de référence, par exemple pour les générateurs de courant de référence, ou de tension de référence ou plus généralement pour tous les schémas analogiques de conversion de tension/courant implémentés dans des générateurs de courant, des convertisseurs analogique-numérique ou des oscillateurs.

La figure 1B représente un exemple de circuit de génération d'un courant de référence. La tension de référence $V_{ref}$ utilisées dans un tel circuit est généralement fournie par un circuit « bandgap » délivrant une tension « élevée » (classiquement 1,2V). Si on veut également avoir une consommation électrique moindre, il est nécessaire que le courant circulant dans la résistance soit le plus faible possible. Ainsi, comme pour l'oscillateur, il est nécessaire que la résistance présente une valeur élevée. On notera en outre que ce type de circuit nécessite également l'utilisation d'une résistance insensible aux variations de température si on veut obtenir un courant de référence généré invariant en température. US 2016/352339 A1 divulgue une source de courant PTAT pour polariser un oscillateur en anneau, dans laquelle un circuit de réglage de polarisation ajuste la tension de la grille en face arrière d'au moins un transistor de la source de courant PTAT.

L'invention vise à remédier aux inconvénients précités de l'art antérieur, en proposant un circuit électronique diviseur de tension réalisé en technologie FDSOI (transistor sur couche mince isolante).

Conformément à l'invention, ce but est atteint grâce à une utilisation astucieuse des polarisations de grille arrière de transistors de type FDSOI d'un circuit utilisé habituellement pour réaliser une source de courant.

Un objet de l'invention est donc un circuit électronique diviseur de tension, conformément à la revendication indépendante 1 en annexe, comprenant au moins deux transistors sur couche mince isolante FDSOI d'un premier type reliés à un premier potentiel d'alimentation et agencés en une structure de miroir de courant et deux transistors sur couche mince FDSOI d'un second type et une charge électrique d'impédance non nulle, les transistors ayant chacun une grille

**EP 3 832 430 B1**

principale en face avant et une grille de réglage en face arrière, un drain d'un premier transistor du second type étant relié au drain d'un premier transistor du premier type, un drain d'un deuxième transistor du second type étant relié au drain d'un deuxième transistor du premier type, le drain du premier transistor du second type étant relié à la grille en face avant de ce même transistor, les grilles en face avant des premier et deuxième transistors du second type étant reliées entre elles, la source du premier transistor du second type étant reliée à un second potentiel d'alimentation et ladite charge d'impédance non nulle étant placée entre la source du second transistor du second type et ledit second potentiel d'alimentation, caractérisé en ce que les grilles en face arrière des premier et deuxième transistors de second type sont reliées à un circuit externe appliquant une tension d'entrée non nulle entre ces deux grilles en face arrière, de telle sorte que la grille en face arrière du première transistor du second type soit amenée à un potentiel ($V_{BBN1}$) inférieur à celui ($V_{BBN2}$) de la grille face arrière du deuxième transistor du second type si ces deux transistors sont de type nMOS, et que la grille en face arrière du première transistor du second type soit amenée à un potentiel ($V_{BBP}1$) supérieur à celui ($V_{BBP2}$) de la grille face arrière du deuxième transistor du second type si ces deux transistors sont de type pMOS, moyennant quoi la tension aux bornes de ladite charge constitue une tension de sortie égale à une fraction de la tension d'entrée.

Un autre objet de l'invention est un système électronique comprenant un tel circuit électronique et comprenant un troisième transistor du premier type dont la source est reliée au premier potentiel d'alimentation, la grille étant reliée aux grilles des premier et deuxième transistors du premier type, et le drain étant relié à un nœud relié à un circuit de charge.

Des modes de réalisation particuliers du circuit électronique diviseur de tension et du système électronique constituent l'objet des revendications dépendantes.

D'autres caractéristiques, détails et avantages de l'invention ressortiront à la lecture de la description faite en référence aux figures annexées données à titre d'exemple et qui représentent, respectivement :

- [Fig.1A], déjà décrite, un oscillateur en anneau comprenant une boucle d'inverseurs selon l'art antérieur;
- [Fig.1B], déjà décrite, une source de courant comprenant une résistance et un circuit d'asservissement de la tension aux bornes de la résistance selon l'art antérieur;
- [Fig. 2], un transistor de type FDSOI selon l'art antérieur ;
- [Fig.3], un circuit électronique générateur d'une tension de référence selon un premier mode de réalisation de l'invention ;
- [Fig. 4] et [Fig. 5], le rapport entre deux potentiels en fonction de la température pour deux types de transistors du circuit selon le premier mode de réalisation de l'invention ;
- [Fig. 6], un circuit électronique selon un second mode de réalisation de l'invention ;
- [Fig. 7], un oscillateur en anneau selon un premier mode de réalisation de l'invention ;
- [Fig. 8], la fréquence d'oscillation en fonction de la température de l'oscillateur selon le premier mode de réalisation de l'invention déterminée par simulation ;
- [Fig. 9], un oscillateur en anneau selon un second mode de réalisation de l'invention ;
- [Fig. 10], un générateur de courant réalisé à partir d'un circuit selon l'invention ; et
- [Fig. 11a] et [Fig. 11b], des résultats de simulations obtenus pour le générateur de courant de la figure 10.

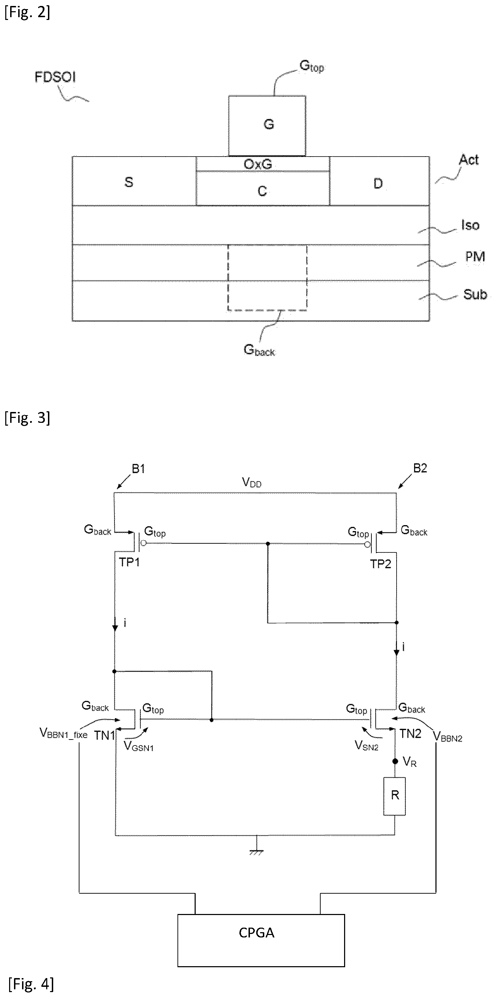

[Fig. 2] représente la structure interne d'un transistor FDSOI (transistor réalisé sur une couche mince isolante). Le transistor FDSOI comprend une couche d'un substrat de silicium de type p Sub, une couche enterrée d'un matériau isolant Iso, aussi appelée BOX, séparée du substrat Sub par un plan de masse PM. La couche isolante Iso est surmontée d'une couche active de silicium Act dans laquelle sont placés une source S, un canal C et un drain D. Le plan de masse PM (ou caisson NWELL ou PWELL selon son dopage) permet d'améliorer le contrôle électrostatique du transistor en limitant la pénétration des champs électriques générés par le drain D et la source S sous le canal C. Le canal C est recouvert d'une couche d'oxyde de grille OxG. L'oxyde de grille OxG est surmonté d'une grille métallique G. Le transistor FDSOI présente une grille en face avant Gtop et une grille en face arrière $G_{back}$. La grille en face avant $G_{top}$ est la grille principale permettant de choisir le mode de fonctionnement du transistor (non passant, passant). La grille en face arrière Gback constitue quant à elle une grille de réglage, la tension appliquée sur cette grille arrière permettant de faire varier les caractéristiques de fonctionnement du transistor, notamment sa tension de seuil.

De façon générale, il est possible de faire varier la tension de seuil $V_{th}$ des transistors FDSOI en jouant sur le dopage n ou p du caisson PM, sur le métal de connexion de la grille et sur la tension de caisson par rapport à la tension de source appliquée sur le transistor. Pour fournir différents types de transistor (tension de seuil $V_{th}$ différente), le procédé de fabrication s'appuie sur le métal de connexion de la grille et sur le dopage du caisson (n ou p). Un transistor à faible $V_{th}$, dit transistor LVT (« Low Threshold Voltage » en anglais), aura une tension $V_{th}$ plutôt faible (de l'ordre de 400 à 450 mV) et un transistor à fort $V_{th}$, dit transistor RVT (« Regular Threshold Voltage » en anglais) aura une tension $V_{th}$ plutôt plus élevée (de l'ordre de 500 à 550 mV).

Dans l'utilisation des transistors, la modification dynamique de la tension de seuil $V_{th}$ des transistors intervient en modifiant la différence de tension entre le caisson et la source, ce qui permet avantageusement d'obtenir des tensions de seuil $V_{th}$ plus faibles avec les transistors LVT (classiquement utilisé pour accélérer sa vitesse) et d'obtenir des tensions de

3

seuil $V_{th}$ plus élevées avec les transistors RVT (classiquement utilisé pour maîtriser et limiter les fuites statiques). En effet, un plan de masse PM du même type que la source S et le drain D permet d'obtenir un transistor FDSOI présentant une valeur faible de tension de seuil $V_{th}$, tandis qu'un plan de masse PM de type différent de la source S et du drain D permet d'obtenir un transistor FDSOI ayant une valeur de tension de seuil $V_{th}$ élevée.

Un transistor FDSOI nMOS LVT présente donc un drain D et une source S dopés n et un plan de masse PM dopé n (c'est-à-dire un caisson NWELL dopé n), tandis qu'un transistor nMOS RVT présente un drain D et une source S dopés n et un plan de masse PM dopé p (c'est-à-dire un caisson PWELL dopé p).

Un transistor FDSOI pMOS LVT présente un drain D et une source S dopés p et un plan de masse PM dopé p (c'est-à-dire un caisson PWELL dopé p), tandis qu'un transistor FDSOI pMOS RVT présente un drain D et une source S dopés p et un plan de masse PM dopé n (c'est-à-dire un caisson NWELL dopé n).

Une description détaillée des différentes possibilités de réalisation de transistors présentant des plages de tensions de seuil plus ou moins élevées est réalisée dans le brevet EP2415079 de la demanderesse.

[Fig.3] représente un circuit électronique diviseur de tension selon un premier mode de réalisation de l'invention. Deux transistors FDSOI de type pMOS TP1 et TP2 sont connectés entre eux de façon à réaliser un miroir de courant. La source du transistor TP1 et la source du transistor TP2 sont reliées à un même potentiel d'alimentation $V_{DD}$, la grille en face avant $G_{top}$ du transistor TP1 est reliée à la grille en face avant du transistor TP2 et la grille en face avant du transistor TP2 est reliée au drain du transistor TP2.

On considère que les transistors TP1 et TP2 sont identiques, donc leurs rapports W/L sont identiques, avec W la largeur du canal et L la longueur de la grille en face avant $G_{top}$ de chacun des transistors. Le miroir de courant forme deux branches B1 et B2 dans lesquelles circule un même courant électrique i.

Ce miroir de courant est relié à une paire de transistors FDSOI de type nMOS TN1 et TN2. Le drain du transistor TP1 est relié au drain du transistor TN1 et le drain du transistor TP2 est relié au drain du transistor TN2. La source du transistor nMOS TN1 est reliée à une masse électrique.

Une résistance R est placée entre la source du transistor TN2 et la masse électrique. Le drain du transistor TN1 est relié à la grille en face avant $G_{top}$ du transistor TN1 et les deux grilles en face avant $G_{top}$ des transistors TN1 et TN2 sont reliées entre elles.

Les grilles en face arrière $G_{back}$ des quatre transistors FDSOI TN1, TN2, TP1 et TP2 sont polarisées par un circuit « externe » CPGA. Plus particulièrement, les grilles arrière Gback des transistors TN1 et TN2 sont respectivement polarisées à des potentiels $V_{BBN1}$ et $V_{BBN2}$ tandis que les grilles arrières $G_{back}$ des autres transistors TP1 et TP2 sont maintenues à un potentiel constant, égal dans cet exemple au potentiel de la masse. Comme on le comprendra à lecture des explications infra, pour que le circuit soit fonctionnel (qu'un courant circule dans les branches) il faut que les potentiels $V_{BBN2}$ et $V_{BBN1}$ soient différents, en pratique significativement différents, et qu'ils soient tels que $V_{BBN2} > V_{BBN1}$.

On note $V_R$ le potentiel de la source du transistor TN2 (correspondant à la tension aux bornes de la résistance R), et ce potentiel $V_R$ vaut i x R, i étant le courant circulant dans les deux branches B1 et B2.

On note également la capabilité d'un transistor $\beta = (W/L) \times \mu \times C_{ox}$, avec (W/L) le rapport entre la largeur W et la longueur L du canal du transistor, $\mu$ la mobilité des porteurs de charge et $C_{ox}$ la capacité d'oxyde de grille du transistor.

On peut écrire pour le transistor TN1 que le courant i est égal à :

$$i = \beta_{TN1} J_{D0} \exp\left(\frac{V_{GTN1} - V_{ThTN1}}{n V_T}\right)\left(e^{-V_{STN1}/V_T} - e^{V_{DTN1}/V_T}\right) \qquad (1)$$

Avec $\beta_{TN1}$ la capabilité du transistor TN1, $J_{D0}$ une constante représentant le seuil de saturation des transistors, n le facteur de pente (ou « slope factor » en anglais), $V_{GTN1}$ le potentiel de grille en face avant $G_{top}$ du transistor TN1, $V_{ThTN1}$ la tension de seuil du transistor TN1, $V_T$ la tension thermique des transistors, $V_{STN1}$ le potentiel de source du transistor TN1 et $V_{DTN1}$ le potentiel de drain du transistor TN1.

On peut également écrire pour le transistor TN2 que le courant i est égal à :

$$i = \beta_{TN2} J_{D0} \exp\left(\frac{V_{GTN2} - V_{ThTN2}}{n V_T}\right)\left(e^{-V_{STN2}/V_T} - e^{V_{DTN2}/V_T}\right) \qquad (2)$$

Avec $\beta_{TN2}$ la capabilité du transistor TN2, $V_{GTN2}$ le potentiel de grille en face avant Gtop du transistor TN2, $V_{ThTN2}$ la tension de seuil du transistor TN2, $V_{STN2}$ le potentiel de source du transistor TN2 et $V_{DTN2}$ le potentiel de drain du transistor TN2.

On peut développer l'équation (1) pour obtenir :

$$i = \beta_{TN1} J_{D0} \exp\left(\frac{V_{GTN_1} - V_{ThTN_1}}{nV_T}\right)\left(1 - e^{V_{STN_1}/V_T - V_{DTN_1}/V_T}\right) e^{-V_{STN_1}/V_T} \quad (3)$$

Or, les termes $e^{V_{STN_1}/V_T - V_{DTN_1}/V_T}$ et $e^{V_{STN_2}/V_T - V_{DTN_2}/V_T}$ sont quasi identiques entre le transistor TN1 et le transistor TN2 avec un montage cascode (décrit infra), et très proche sans montage cascode. On peut donc combiner les équations (2) et (3) pour obtenir le développement suivant :

$$\beta_{TN1} J_{D0} \exp\left(\frac{V_{GTN_1} - V_{ThTN_1}}{nV_T}\right) e^{-V_{STN_1}/V_T} = \beta_{TN2} J_{D0} \exp\left(\frac{V_{GTN_2} - V_{ThTN_2}}{nV_T}\right) e^{-V_{STN_2}/V_T} \quad (4)$$

Comme la source du transistor TN1 est reliée à la masse électrique, le potentiel $V_{STN1}$ de la source du transistor TN1 est nul. De plus, le potentiel $V_{STN2}$ de la source du transistor TN2 vaut $V_R$. L'équation (4) devient :

$$\beta_{TN1} \exp\left(\frac{V_{GTN_1} - V_{ThTN_1}}{nV_T}\right) = \beta_{TN2} \exp\left(\frac{V_{GTN_2} - V_{ThTN_2}}{nV_T}\right) e^{-V_R/V_T} \quad (5)$$

$$\frac{\beta_{TN_1}}{\beta_{TN_2}} = \exp\left(-\frac{V_{GTN_1} - V_{ThTN_1}}{nV_T}\right) \exp\left(\frac{V_{GTN_2} - V_{ThTN_2}}{nV_T}\right) e^{-V_R/V_T} \quad (6)$$

$$\ln\left(\frac{\beta_{TN_1}}{\beta_{TN_2}}\right) = -\frac{V_{GTN_1} - V_{ThTN_1}}{nV_T} + \left(\frac{V_{GTN_2} - V_{ThTN_2}}{nV_T}\right) - \frac{V_R}{V_T} \quad (7)$$

$$\ln\left(\frac{\beta_{TN_1}}{\beta_{TN_2}}\right) = \frac{V_{GTN_2} - V_{GTN_1} + V_{ThTN_1} - V_{ThTN_2} - nV_R}{nV_T} \quad (8)$$

$$V_R = V_T \ln\left(\frac{\beta_{TN_2}}{\beta_{TN_1}}\right) + \frac{V_{GTN_2} - V_{GTN_1}}{n} + \frac{V_{ThTN_1} - V_{ThTN_2}}{n} \quad (9)$$

Les grilles des transistors TN1 et TN2 étant reliées entre elles, leur différence de potentiel ($V_{GTN2} - V_{GTN1}$) est nulle. On note la différence entre les tensions de seuil des deux transistors TN1 et TN2 $\Delta V_{th}$ avec $\Delta V_{th} = V_{ThTN2} - V_{ThTN1}$. L'équation (9) devient donc :

$$V_R = V_T \ln\left(\frac{\beta_{TN_2}}{\beta_{TN_1}}\right) - \frac{\Delta V_{th}}{n} \quad (10)$$

Or d'après le mémoire de thèse d'Alyssa Bonnoit, « Reducing power using body biasing in microprocessors with dynamic voltage/frequency scaling », le mémoire de thèse de Jean-Philippe Noël, « Optimisation de dispositifs FDSOI pour la gestion de la consommation et de la vitesse : application aux mémoire et fonctions logiques », et la présentation d'Andreia Cathelin « Analog/RF design techniques in 28 nm FDSOI technology » de 2017 lors du SOI Industry Consortium, on peut écrire que $\Delta V_{th} = \alpha(V_{BBN1\_fixe} - V_{BBN2} + V_R)$, avec $\alpha$ un réel.

L'équation (10) devient donc :

$$V_R = V_T \ln\left(\frac{\beta_{TN_2}}{\beta_{TN_1}}\right) - \frac{\alpha(-V_{BBN2} + V_R + V_{BBN1})}{n} \quad (11)$$

$$V_R\left(\frac{n+\alpha}{n}\right) = V_T \ln\left(\frac{\beta_{TN_2}}{\beta_{TN_1}}\right) - \frac{\alpha V_{BBN_1}}{n} + \frac{\alpha(V_{BBN_2})}{n} \quad (12)$$

$$V_R = V_T \frac{n}{n+\alpha} \ln\left(\frac{\beta_{TN_2}}{\beta_{TN_1}}\right) + \frac{\alpha(V_{BBN_2} - V_{BBN_1})}{n+\alpha} \quad (13)$$

On constate à partir de l'équation (13) que le potentiel $V_R$ est lié à la différence de potentiel $V_{BBN2}$ - $V_{BBN1}$ par une relation linéaire dans le second terme de l'équation.

Le terme $V_T \frac{n}{n+\alpha} \ln\left(\frac{\beta_{TN_2}}{\beta_{TN_1}}\right)$ est nul devant le terme $\frac{\alpha(V_{BBN_2} - V_{BBN_1})}{n+\alpha}$ si les rapports W/L des transistors TN1 et TN2 sont identiques. L'équation (13) devient alors :

$$V_R = \frac{\alpha(V_{BBN_2} - V_{BBN_1})}{n+\alpha} \quad (14)$$

Cette équation 14 permet de constater clairement que le circuit proposé permet bien de réaliser un diviseur de tension, le facteur de division étant égal à $\frac{\alpha}{n+\alpha}$.

De façon générique, on constate que l'équation (13) est composée de deux termes A+B, avec A et B définis comme suit :

$$A = V_T \frac{n}{n+\alpha} \ln\left(\frac{\beta_{TN_2}}{\beta_{TN_1}}\right)$$

$$B = \frac{\alpha(V_{BBN_2} - V_{BBN_1})}{n+\alpha}$$

En choisissant des transistors TN1 et TN2 différents (donc ayant des rapports W/L différents), il est possible d'introduire une compensation en température, comme cela est expliqué infra. Néanmoins, même si les rapports W/L des transistors TN1 et TN2 sont choisis différents, en pratique légèrement différents (par exemple de 10% voire 20% au maximum, le pourcentage étant entendu par rapport à la valeur W/L la plus grande), le premier terme A sera souvent plus faible que le terme B si les potentiels $V_{BBN2}$ et $V_{BBN1}$ sont significativement différents. On notera que le terme A peut être positif ou négatif selon que le transistor TN2 est respectivement plus grand ou plus petit que le transistor TN1.

A titre de comparaison, dans le cas où le circuit de la figure 3 serait utilisée comme dans l'art antérieur pour former une source de courant, avec des potentiels de grille arrière identiques pour $V_{BBN2}$ et $V_{BBN1}$, on aurait un rapport 1 à 8 entre les tailles des transistors TN1 et TN2 pour avoir une tension suffisante aux bornes de la résistance. Le terme B serait alors égal à 0 et la tension $V_R$ serait obtenue uniquement grâce au terme A, en utilisant des géométries très significativement différentes pour TN1 et TN2 pour que le terme A ne soit pas trop petit. Au contraire, dans un circuit diviseur de tension selon la présente invention, on va davantage privilégier le terme B grâce à la tension d'entrée se traduisant par des potentiels $V_{BBN2}$ et $V_{BBN1}$ différents. Le terme A est introduit uniquement dans le cas où l'on souhaite compenser les variations en température de la résistance. A titre d'exemple, pour une même tension $V_R$ aux bornes de la résistance, on a un rapport 11 / 12 (comprendre : les transistors TN1 et TN2 ont respectivement 11 et 12 doigts élémentaires) avec le circuit de la figure 3, avec une tension d'entrée de 2V (différence entre les potentiels $V_{BBN2}$ et $V_{BBN1}$).

De plus, dans le cas où l'un des potentiels $V_{BBN1}$ ou $V_{BBN2}$ est égal au potentiel standard Vss définissant la masse électrique on pourra simplifier l'équation (14), et considérer que le terme $\frac{\alpha V_{BBN(2\,ou\,1)}}{n+\alpha}$ est quasi nul.

Ce développement susmentionné est appliqué dans le cas d'un fonctionnement en mode faible inversion (ou « weak inversion » en anglais) des transistors TN1 et TN2, autrement dit dans le cas de transistors TN1 et TN2 en conduction sous le seuil.

Le circuit proposé permet donc d'abaisser la tension $V_R$ aux bornes de la résistance R par rapport à la tension d'entrée égale à $V_{BBN2}$ - $V_{BBN1}$, tout en conservant une faible valeur de courant i dans les deux branches B1 et B2 et une valeur de résistance R permettant de minimiser l'encombrement en terme de surface silicium.

Il est possible de réaliser le même raisonnement pour des transistors TN1 et TN2 en fonctionnement d'inversion forte (ou « strong inversion » en anglais) avec $V_{DS}$ > $V_{GS}$ - $V_T$, (et $V_{GS}$ > $V_T$) où $V_{DS}$ est la tension entre le drain et la source d'un transistor, $V_{GS}$ la tension entre la grille avant et la source du même transistor et $V_T$ est la tension thermique du transistor. Le courant dans les transistors TN1 et TN2 s'écrit :

$$i = \frac{\beta}{2}(V_{GS} - V_{th})^2(1 + \lambda V_{DS}) \quad (15)$$

Avec $\beta$ la capabilité du transistor, $V_{GS}$ la tension entre la grille et la source du transistor, $V_{th}$ la tension de seuil du transistor, $V_{DS}$ la tension entre le drain et la source du transistor et $\lambda$ le coefficient de modulation de la longueur de canal.

Le courant i est identique dans les deux transistors TN1 et TN2 du fait de la structure en miroir de courant, on peut donc écrire : $\beta_{TN1}(V_{GTN1} - V_{STN1} - V_{ThTN1})^2(1 + \lambda_{DSTN1}) = \beta_{TN2}(V_{GTN2} - V_{STN2} - V_{ThTN2})^2(1 + \lambda_{DSTN2})$

Pour les mêmes raisons que précédemment, on peut négliger les deux termes $(1 + \lambda V_{DSTN2})$ et $(1 + \lambda V_{DSTN1})$ et obtenir :

$$V_R = \frac{1}{\alpha+1}\frac{T}{T_0}\sqrt{\frac{2I}{\mu_0 C_{ox}\frac{W_1}{L_1}}}\left(1 - \frac{1}{\sqrt{K}}\right) + \frac{\alpha}{\alpha+1}\left(V_{BBN2} - V_{BBN1\_}\right) \quad (17)$$

Comme précédemment, l'équation (17) peut s'écrire sous la forme $V_R$ = A+B avec

$$A = \frac{1}{\alpha+1}\frac{T}{T_0}\sqrt{\frac{2I}{\mu_0 C_{ox}\frac{W_1}{L_1}}}\left(1 - \frac{1}{\sqrt{K}}\right)$$

$$B = \frac{\alpha}{\alpha+1}\left(V_{BBN2} - V_{BBN1\_}\right)$$

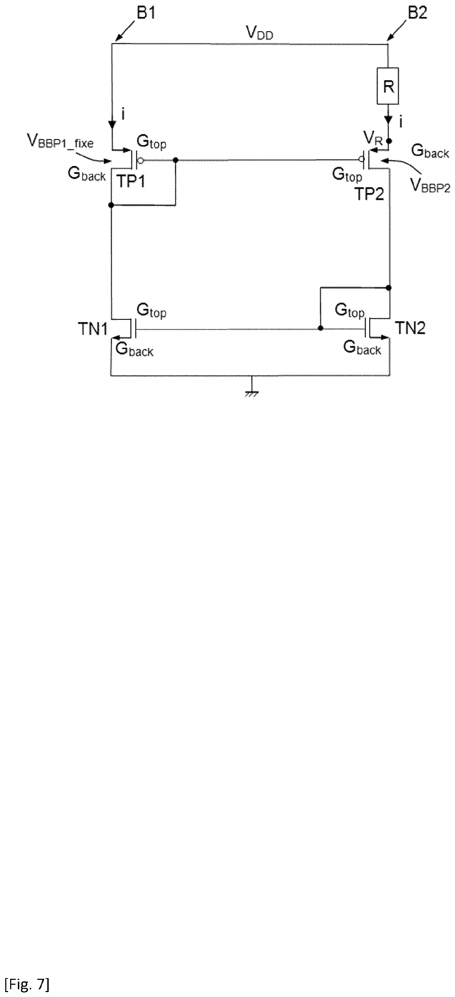

Le rapport entre le potentiel $V_R$ et la différence $V_{BBN2}$ - $V_{BBN1\_}$ est donc sensiblement constant, quel que soit le régime de fonctionnement des transistors TN1 et TN2 car n est proche de 1 en technologie FDSOI (autour de 1,2 à 1,6). Cela est généralisable en inversant la structure comme décrit plus précisément en référence à la figure 6.

Selon un mode de réalisation possible, le transistor TN2 a une largeur de grille en face avant $G_{top}$ supérieure à celle du transistor TN1 (ou plus précisément W2/L2 > W1/L1), ce qui permet d'obtenir un effet « proportionnel à la température » (PTAT, ou en anglais « Proportional to Absolute Temperature ») sur le courant i circulant dans la résistance R à cause des valeurs de tensions entre la grille et la source des transistors qui augmentent avec la température. Cela s'explique par le fait que $V_{GS1}$ - $V_{GS2}$ = $V_R$, donc si les tensions $V_{GS}$ augmentent, alors $V_R$ augmente également donc le courant i aussi. Cela permet de compenser un coefficient de température positif de la résistance R qui entraîne un effet « inversement proportionnel à la température (CPTAT, ou en anglais « Conversely Proportional to Absolute Temperature ») sur le courant i. Les deux effets CPTAT et PTAT se compensent donc et le rapport entre $V_R$ et $V_{BBN2}$-$V_{BBN1\_fixe}$ reste stable en température. Cela s'explique également par le fait que le coefficient A dans la formule (14) ou (17) est fonction de $V_T$ est positif. $V_T$ augmentant avec la température, la variation de A et donc de $V_R$ sera positive si

$$\beta_{TN2} > \beta_{TN1}$$

donc si le transistor TN2 est plus gros que le transistor TN1.

Dans le cas, moins fréquent, où la résistance utilisée présente un coefficient de température négatif entraînant un effet PTAT sur le courant i, il est possible de compenser cet effet PTAT par un effet CPTAT en déséquilibrant inversement les ratios géométriques des transistors TN2 et TN1, en prenant W2/L2 < W1/L1. Cela s'explique également par le fait que le coefficient A sera dans ce cas négatif. $V_T$ augmentant avec la température, la variation de A et donc de $V_R$ sera négative si

$\beta_{TN2} < \beta_{TN1}$, donc si le transistor TN2 est plus petit que le transistor TN1.

Le circuit représenté en figure 3 peut être réalisé en utilisant des transistors LVT ou RVT. Le choix du type de transistors LVT ou RVT pour les transistors TN1 et TN2 dépend de l'application envisagée et des possibilités de fabrication technologiques des transistors FDSOI, notamment pour la réalisation des caissons Nwell / Pwell placés sous la couche d'oxyde mince et la réalisation de caissons d'isolation profonds permettant de séparer un caisson Pwell du substrat « massif », généralement de type P. Comme cela est bien connu de l'homme de l'art, dans le cas où le caisson Nwell ou Pwell est polarisé à une tension différente du substrat, et éventuellement du caisson profond « Deep Nwell », il faut s'assurer que les diodes présentes entre caisson/substrat ou caisson/Deep Nwell ne soient pas conductrices.

Le circuit de diviseur de tension peut être utilisé avec des potentiels d'entrée, sur $V_{BBN1}$ et $V_{BBN2}$, qui soient chacun fixe ou variable.

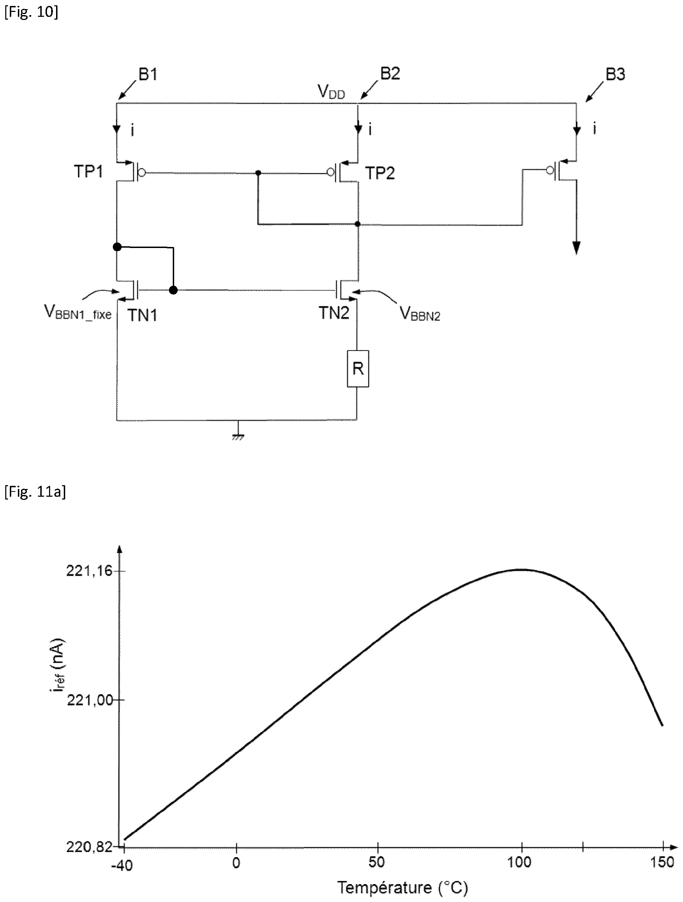

Les 2 potentiels d'entrée, et donc la tension d'entrée, sera fixe si le diviseur de tension est par exemple utilisé pour générer l'équivalent d'une tension de référence $V_R$ « basse » à partir d'une tension de référence « élevée » par exemple fournie par un circuit classiquement dénommé par l'acronyme anglais « bandgap », une telle tension de référence basse pouvant entre autre être utilisé dans un circuit de source de courant de référence comme cela est décrit infra en relation avec la figure 10.

La tension d'entrée pourra être variable, par exemple en faisant varier au moins l'un des deux potentiels. Dans l'exemple de circuit oscillateur décrit infra, l'un des potentiels, $V_{BBN1}$, est fixe et l'autre potentiel, $V_{BBN2}$, peut varier dans une plage de valeurs donnée. Dans le cas où le circuit diviseur serait par exemple relié à un capteur fournissant un signal différentiel, les deux potentiels pourraient être amenés à fluctuer.

Quelle que soit l'application envisagée d'un tel circuit de diviseur de tension, le choix de transistors LVT ou RVT sera principalement guidé par la simplicité de mise en œuvre du circuit. Si au moins l'un des potentiels est négatif, il sera plus aisé d'utiliser des transistors nMOS RVT pour pouvoir polariser négativement le PWELL et l'isoler du substrat à la masse, par un caisson profond DeepNWELL. Inversement, si les potentiels sont plutôt positifs, ou très faiblement négatifs (supérieur à -0,6V) on pourra utiliser des transistors LVT car il est possible de polariser le caisson Nwell à ces valeurs sans rendre conductrice la diode Nwell/Psubstrat.

Selon un mode de réalisation possible, les transistors TN1, TN2, TP1 et TP2 sont des transistors comprenant plusieurs « doigts » (ou « fingers » en anglais), par exemple des doigts identiques ; le transistor TN1 comprend X « doigts » et le transistor TN2 comprend X + K « doigts » avec X et K deux entiers, ou inversement si on souhaite éventuellement que le transistor TN2 soit plus petit que le transistor TN1.

L'avantage d'utiliser des transistors FDSOI est de pouvoir accéder à une plage de valeurs étendue en potentiel de polarisation $V_{BBN2}$ ou $V_{BBN1}$ de la grille arrière Gback du transistor FDSOI TN2 ou TN1 (ou les 2 éventuellement) et ainsi d'avoir également une plage de valeurs étendue en tension de seuil $V_{th}$ du transistor TN2 et/ou TN1, comme le montre la présentation d'Andreia Cathelin « Analog/RF design techniques in 28 nm FDSOI technology » de 2017 faite lors du SOI Industry Consortium. Cela entraîne un facteur $\alpha$ (équation (11)) faible et donc permet de réduire plus fortement le potentiel $V_R$ (ou tension aux bornes de la résistance) par rapport à la tension d'entrée $V_{BBN2} - V_{BBN1}$, et ainsi de limiter de manière plus avantageuse l'encombrement de la résistance R sur la surface silicium lorsque l'on souhaite utiliser un courant de polarisation de faible valeur pour limiter la consommation.

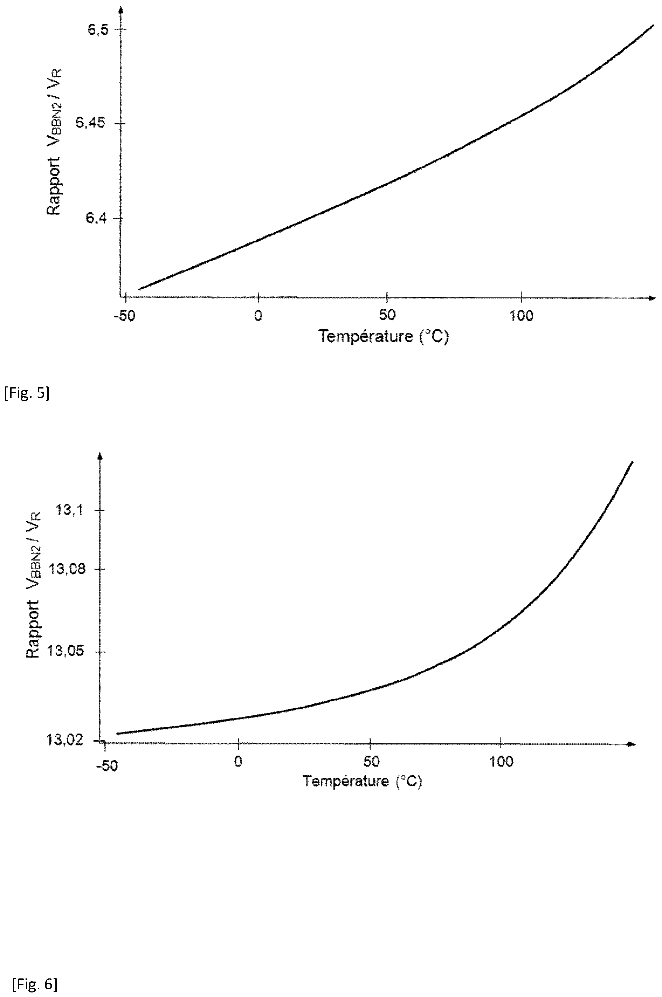

[Fig. 4] présente des résultats de simulations réalisées avec le circuit de la figure 3 dans lequel les transistors TN1 et TN2 sont de même taille et de type LVT GO1, c'est-à-dire que leur épaisseur d'isolant en face arrière permet de supporter une tension d'environ 1 V sur la grille avant $G_{back}$ du transistor, et la résistance R ne présente aucun coefficient

$$\frac{V_{BBN2}}{V_R} \sim \frac{n+\alpha}{\alpha}$$

de température. Le potentiel $V_{BBN1}$ est dans cet exemple égal à celui de la masse, donc nul. Le rapport

est représenté en ordonnées et la température du circuit (donc de tous les transistors de la figure 3) est représentée en

$$\frac{V_{BBN2}}{V_R} \sim \frac{n+\alpha}{\alpha}$$

abscisses. On constate que pour une température variant entre -45 °C et 150 °C, le rapport                varie entre 6,36 et 6,5. On peut donc considérer que ce rapport est peu sensible à la température du circuit. Le rapport

$$\frac{V_{BBN2}}{V_R} \sim \frac{n+\alpha}{\alpha}$$

varie beaucoup plus en température si l'on effectue ces simulations avec une résistance R ayant un coefficient de température. C'est pour cela que les transistors TN1 et TN2 ont avantageusement des rapports W/L différents pour compenser la variation de température.

Le circuit proposé en figure 3 permet donc bien de réaliser un circuit diviseur de tension, en considérant que $V_{BBN2}$-$V_{BBN1}$ est la tension d'entrée et la tension aux bornes de la charge (égale, dans le cas présent, à $V_R$) est la tension de sortie, obtenue en divisant $V_{BBN2}$ par un facteur $\frac{n+\alpha}{\alpha} > 1$ peu sensible à la température, et donc de réaliser un circuit de génération d'une tension de référence comprenant une résistance de référence peu encombrante.

[Fig. 5] présente des résultats de simulations réalisées avec le circuit de la figure 3 dans lequel les transistors TN1 et TN2 sont toujours de même taille mais de type LVT GO2. Ils présentent donc une épaisseur d'isolant deux fois plus grande (transistors de type GO2), ce qui leur permet de supporter une plus grande tension de polarisation sur leur grille avant. Le rapport $\frac{V_{BBN2}}{V_R} \sim \frac{n+\alpha}{\alpha}$ est représenté en ordonnées et la température du circuit de la figure 3 est représentée en abscisses. On constate que pour une température variant entre -45 °C et 150 °C, le rapport $\frac{V_{BBN2}}{V_R} \sim \frac{n+\alpha}{\alpha}$ varie entre 13,02 et 13,12. On peut donc considérer que ce rapport est peu sensible à la température du circuit, et comme précédemment que le circuit proposé en figure 3 permet de réaliser un circuit diviseur de tension peu sensible à la température et pouvant adapter le facteur de division $\frac{V_{BBN2}}{V_R} \sim \frac{n+\alpha}{\alpha}$ grâce à l'épaisseur de la couche d'oxyde mince, d'oxyde de BOX et du film silicium, et ainsi avoir une résistance de référence peu encombrante en terme de surface silicium.

[Fig. 6] représente un second mode de réalisation. Deux transistors FDSOI de type nMOS TN1 et TN2 sont connectés entre eux de façon à réaliser un miroir de courant. Ce miroir de courant est relié à une paire de transistors FDSOI de type pMOS TP1 et TP2. La source du transistor pMOS TP1 est reliée au potentiel $V_{DD}$, et les drains des deux transistors TP1 et TP2 sont reliés respectivement aux drains des transistors nMOS TN1 et TN2. Les sources des transistors nMOS TN1 et TN2 sont reliées à une masse électrique. Une résistance R est placée entre la source du transistor TP2 et le potentiel $V_{DD}$. La grille en face avant du transistor TN2 est reliée à la source du transistor TN2 et les deux grilles en face avant des transistors TN1 et TN2 sont reliées entre elles. La grille en face avant du transistor TP1 est reliée à la source du transistor TP1 et les grilles des transistors TP1 et TP2 sont reliées entre elles. On considère que les transistors TN1 et TN2 sont identiques, donc leurs rapports W/L sont identiques. Le courant i circulant dans les deux branches B1 et B2 formées par le miroir de courant est identique..

Les grilles arrière des quatre transistors FDSOI TN1, TN2, TP1 et TP2 sont polarisées par un circuit externe non représenté, analogue au circuit CPGA de la figure 3. Plus particulièrement, les grilles arrière des transistors TP1 et TP2 sont respectivement polarisées à des potentiels $V_{BBP1}$ et $V_{BBP2}$ tandis que les grilles en face arrière des autres transistors TN1, TN2 sont maintenues à un potentiel constant, égal à la masse dans cet exemple. Comme on le comprendra à lecture des explications infra, pour que le circuit soit fonctionnel (qu'un courant circule dans les branches) il faut que les potentiels VBBP2 et VBBP1 soient différents, en pratique significativement différents, et qu'ils soient tels que $V_{BBP2} < V_{BBP1}$.

On note $V_R$ le potentiel entre la source du transistor TP2 et la résistance R. La tension aux bornes de la résistance R, égale à $V_{DD}-V_R$ vaut i x R où i est le courant circulant dans les deux branches B1 et B2.

On peut appliquer le même raisonnement que celui effectué pour les circuits des figures précédentes, à savoir que le courant i arrivant sur la source du transistor TP1 peut s'écrire :

$$i \sim \beta_{TP1} J_{D0} \exp\left(\frac{V_{GTP1} - V_{ThTP1}}{nV_T}\right) e^{-V_{STP1}/V_T} \qquad (23)$$

Et le courant i arrivant sur la source du transistor TP2 peut s'écrire :

$$i \sim \beta_{TP2} J_{D0} \exp\left(\frac{V_{GTP2} - V_{ThTP2}}{nV_T}\right) e^{-V_{STP2}/V_T} \qquad (24)$$

En combinant les équations (23) et (24) et en se basant sur le mémoire de Jean-Philippe Noël précité, on obtient une relation linéaire liant les potentiels $V_R$ et $V_{BBP2}$ :

$$Vdd - V_R = V_T \frac{n}{n+\alpha} \ln \left( \frac{\beta_{TP_2}}{\beta_{TP_1}} \right) + \frac{\alpha(V_{BBP_1} - V_{BBP_2})}{n+\alpha} \quad (25)$$

Afin, comme précédemment, d'avoir une tension aux bornes de la résistance R (égale à $V_{DD}$-$V_R$), il faut, dans ce cas complémentaire où la tension d'entrée est appliquée entre les grilles arrière des pMOS, que $V_{BBP2}$ soit inférieur à $V_{BBP1}$ et on obtient bien un circuit diviseur de tension. Cela permet ainsi de diminuer la valeur de la résistance R tout en ayant une valeur de courant i faible et une tension d'entrée $V_{BBP1}$ - $V_{BBP2}$ élevée.

De même que précédemment, l'équation (25) peut s'écrire sous la forme A+B avec :

$$A = V_T \frac{n}{n+\alpha} \ln \left( \frac{\beta_{TP_2}}{\beta_{TP_1}} \right)$$

$$B = \frac{\alpha(V_{BBP_1} - V_{BBP_2})}{n+\alpha}$$

Il est alors possible de compenser une éventuelle variation de résistance en fonction de la température en procédant comme décrit précédemment, grâce à la présence du terme A dans la formule donnant la tension $V_{DD}$-$V_R$.

Par ailleurs, sans reprendre tous les développements, en régime saturé, on obtient une équation (26) équivalente à l'équation (17) là aussi avec deux termes A et B comme précédemment.

$$V_{dd} - V_R = \frac{\alpha}{\alpha+1} \left( V_{BBP1} - V_{BBP2\_} \right) \qquad (26)$$

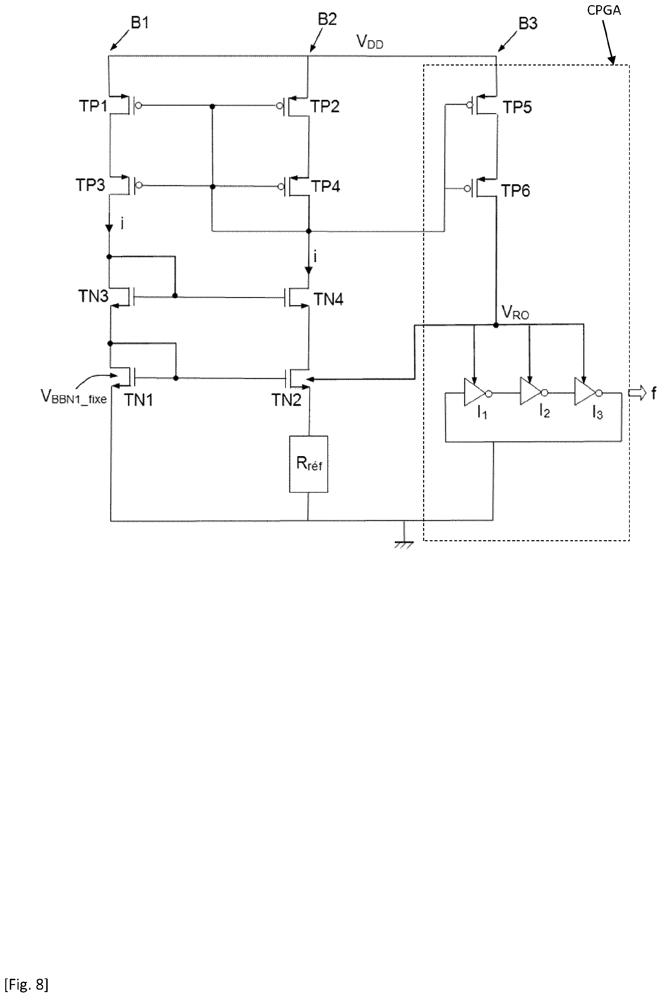

Les circuits présentés permettent de réaliser un diviseur de tension avec une résistance de référence faible et un courant i faible. Ces circuits peuvent avoir différentes applications. Une première application, décrite en référence aux figures 7 à 9, est un circuit de génération d'un signal d'horloge utilisant un oscillateur en anneau.

[Fig. 7] représente un exemple d'un tel circuit de génération d'horloge comprenant un circuit délivrant une tension et un courant à oscillateur en anneau. L'oscillateur comprend trois inverseurs I1, I2, et I3 reliés entre eux de manière à former une boucle. Plus généralement, l'oscillateur peut comprendre 2N+1 inverseurs, avec N un entier naturel supérieur à 1.

En utilisant les circuits électroniques présentés dans les figures précédentes comme générateur de tension/courant de référence pour l'alimentation des inverseurs, on peut avoir une tension $V_{RO}$ aux bornes de la résistance de référence de quelques dizaines de millivolts et un courant i faible tout en ayant des valeurs de résistance de référence $R_{réf}$ faible. En effet, grâce au diviseur de tension réalisé par l'invention, on peut abaisser la tension $V_R$ circulant dans la résistance de référence $R_{réf}$ et ainsi en diminuer la valeur.

Le circuit comprend les même composants que ceux du circuit de la figure 3 et comprend en outre un transistor TP5 reliés aux transistors TP1 et TP2 de manière à former un miroir de courant comprenant ainsi trois branches B1, B2 et B3 dans lesquelles circule un même courant i. Ainsi, les sources des trois transistors TP1, TP2 et TP5 sont reliées à un même potentiel $V_{DD}$, leurs grilles en face avant sont reliées entre elles.

La grille en face arrière du transistor TN2 est relié à un nœud « d'alimentation » présentant un potentiel variable $V_{RO}$ qui est le potentiel d'alimentation des inverseurs I1, I2 et I3. Ce nœud d'alimentation est relié à la branche B3 du miroir de courant, les inverseurs étant donc alimenté par le courant i circulant dans la branche B3. La branche B3 et les trois inverseurs jouent donc le rôle du circuit CPGA de la figure 4

Dans cet exemple de réalisation, le circuit de tension de référence comprend des transistors TN3, TN4, TP3, TP4 et TP6 configurés en montage cascode avec les transistors déjà présents TN1, TN2, TP1, TP2 et TP5. Comme cela est connu de l'homme de l'art, ce montage permet d'assurer une quasi-égalité des tensions VDS des transistors de chaque miroir de courant. Ainsi, en référence aux équations susmentionnées donnant la valeur du courant i, il est possible d'éliminer les composantes liées aux tensions VDS et d'avoir un diviseur de tension « idéal ». Ainsi, les transistors pMOS TP3, TP4, TP6, et nMOS TN3, TN4 sont placés respectivement en série avec les transistors pMOS TP1, TP2, TP5 et les transistors nMOS TN1 et TN2. Le nœud d'alimentation (potentiel $V_{R0}$) est ainsi relié au drain du transistor pMOS TP6.

Les grilles en face arrière de l'ensemble de transistors, excepté le transistor TN2 sont maintenues à un potentiel constant égal dans cet exemple à la masse.

La source du transistor TP3 est reliée au drain du transistor TP1, la source du transistor TP4 est reliée au drain du transistor TP2 et la source du transistor TP6 est reliée au drain du transistor TP5. Les grilles en face avant des transistors TP3 et TP4 sont reliées entre elles. Les grilles en face avant des transistors TP5 et TP6 sont reliées entre elles. Les grilles en face avant des transistors TP3 et TP4 sont reliées aux grilles en face avant des transistors TP1 et TP2. La grille en face avant du transistor TP4 est reliée au drain du transistor TP4 et les grilles en face avant des transistors TP5 et TP6 sont reliées au drain du transistor TP4.

Le drain du transistor TN3 est relié au drain de TP3 et le drain de TN4 est relié au drain de TP4. Les grilles en face avant des transistors TN3 et TN4 sont reliées entre elles. Le drain de TN3 est relié à la grille en face avant du transistor TN3. La source du transistor TN3 est reliée au drain du transistor TN1 et la source du transistor TN4 est reliée au drain du transistor TN2.

Les grilles en face arrière de l'ensemble de transistors, excepté le transistor TN2 sont maintenues à un potentiel constant égal dans cet exemple. La fréquence d'oscillation f de cet oscillateur peut s'écrire en fonction de la résistance équivalente de l'oscillateur en anneau, l'oscillateur constituant une « charge » alimentée par la branche B3 ; $f=1/(n*C*R_{equi})$. Le courant traversant la résistance de référence $R_{réf}$ et égal à celui traversant la résistance équivalente de l'oscillateur en anneau $R_{equi}$, ainsi $i = V_R/R_{réf} = V_{R0}/R_{equi}$. En outre, comme décrit précédemment, $V_{R0} = KBB*V_{Réf}$, avec $KBB>0$. Ainsi, $V_R/R_{réf} = KBB*V_{Rréf}/R_{equi}$, et $R_{equi} = KBB*R_{réf}$. Le circuit de génération d'horloge représenté réalise une boucle d'asservissement de la valeur de la résistance équivalente $R_{equi}$ à la valeur de la résistance de référence multiplié par ce facteur KBB.. Un avantage significatif de ce circuit de génération d'horloge utilisant un diviseur de tension selon la présente invention par rapport au circuit de génération d'horloge représentée en figure 1 est qu'il nécessite une résistance de référence de plus faible valeur que la résistance équivalente souhaitée de l'oscillateur en anneau. Ainsi, comme le rapport KBB peut être important, facilement compris entre 5 et 10, on peut utiliser une résistance 5 à 10 fois plus petite et par conséquent un courant et donc une consommation 5 à 10 fois plus petite que celle du circuit de l'art antérieur.

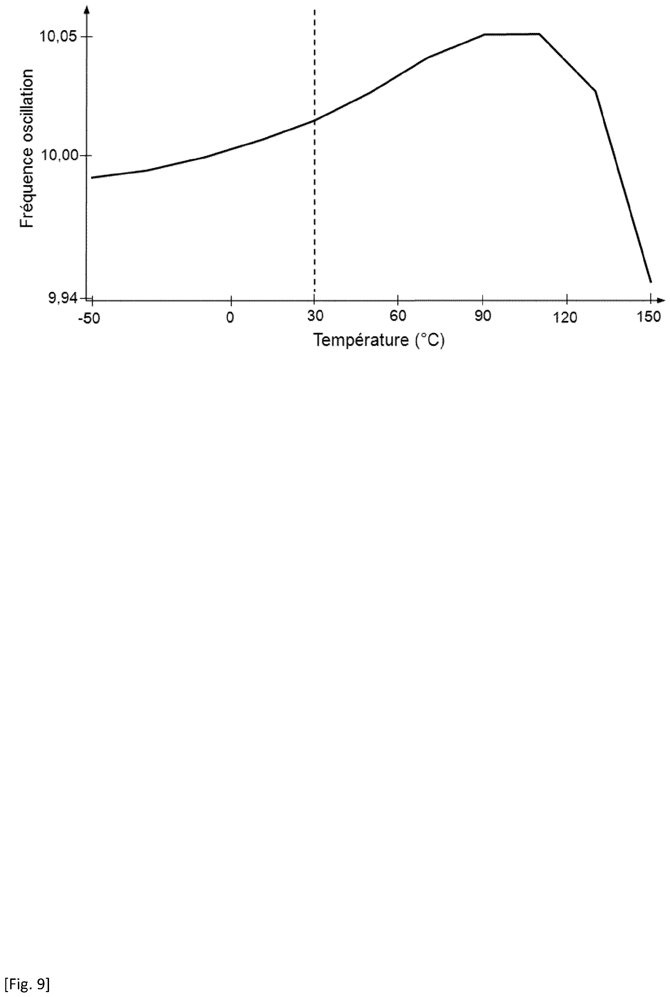

[Fig. 8] présente la fréquence d'oscillation f de l'oscillateur en anneau du circuit de la figure 7 en fonction de la température déterminée par simulations. On constate que la fréquence f est peu sensible à la température du circuit, car elle varie entre 9,04 MHz et 10,06 MHz pour une température variant entre -50 °C et 150 °C. Cela s'explique par le fait que la résistance $R_{réf}$ décroît avec la température mais en ayant des transistors TN1 et TN2 tels que $W2/L2 > W1/L1$, on obtient une stabilité du rapport entre $V_{RO}$ et $V_R$ et donc une stabilité de la fréquence d'oscillation f sur une large plage de température.

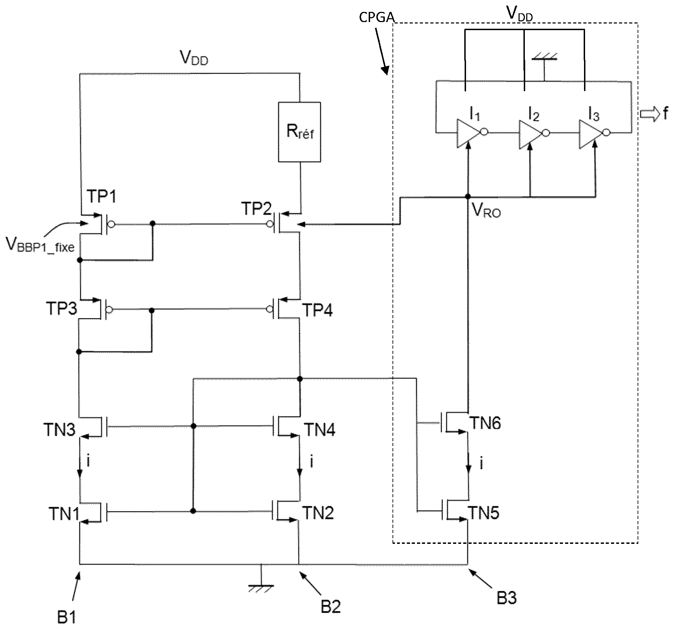

[Fig. 9] représente un circuit de génération d'horloge à base d'oscillateur en anneau selon un autre mode de réalisation de l'invention, complémentaire de celui représenté en figure 7. L'oscillateur comprend trois inverseurs I1, I2, et I3 reliés entre eux de manière à former une boucle. Plus généralement, l'oscillateur peut comprendre 2N+1 inverseurs, avec N un entier naturel supérieur à 1.

Comme précédemment, on utilise un circuit diviseur de tension avec un miroir de courant pour alimenter les inverseurs I1, I2 et I3.

Ainsi, l'oscillateur comprend trois transistors nMOS TN1, TN2 et TN5 reliés entre eux de manière à former un miroir de courant comprenant trois branches B1, B2 et B3 dans lesquelles circule un même courant i. Ainsi, les sources des trois transistors TN1, TN2 et TN5 sont reliées à un même potentiel, qui est ici, une masse électrique. Leurs grilles en face avant sont reliées entre elles.

Il y a également deux transistors pMOS TP1 et TP2 et une résistance $R_{réf}$ placée entre une tension d'alimentation $V_{DD}$ et la source du transistor TP2. Les grilles en face avant des transistors TP1 et TP2 sont reliées entre elles La grille en face avant du transistor TP1 est reliée au drain de TP1.

Le circuit de tension de référence comprend également des transistors configurés en montage cascode avec à savoir des transistors nMOS TN3, TN4 et TN6 et les transistors pMOS TP3 et TP4.

La source du transistor TN3 est reliée au drain du transistor TN1, la source du transistor TN4 est reliée au drain du transistor TN2 et la source du transistor TN6 est reliée au drain du transistor TN5. Les grilles en face avant des transistors TN1, TN2, TN3, TN4, TN5 et TN6 sont reliées entre elles et sont reliées au drain du transistor TN4.

Le drain du transistor TP3 est relié au drain de TN3 et le drain de TN4 est relié au drain de TP4. Les grilles en face avant de TP3 et TP4 sont reliées entre elles reliées à la grille en face avant du transistor TP3. La source de TP3 est reliée au drain de TP1 et la source de TP4 est reliée au drain de TP2.

La branche B3 est reliée à une borne d'alimentation basse de l'oscillateur en anneau. Autrement dit, les inverseurs de l'oscillateur sont placés entre une tension d'alimentation « haute » $V_{DD}$ et une tension d'alimentation basse, correspondant dans ce circuit à un nœud d'alimentation présentant un potentiel $V_{R0}$. Ce nœud d'alimentation est relié à la branche B3, plus précisément au drain du transistor TN6, et est relié également à la grille arrière du transistor TP2. La branche B3 et les trois inverseurs jouent donc le rôle du circuit CPGA de la figure 4.

Les grilles en face arrière de tous les transistors, excepté le transistor TP2, sont également maintenues à un potentiel fixe, égal par exemple à la masse.

[Fig. 10] présente une seconde application des circuits selon l'invention, à savoir un générateur de courant. Le courant généré $i_{réf}$ est dans cet exemple égal au courant i issu des trois branches B1, B2 et B3 du miroir de courant formé par les trois transistors pMOS TP1, TP2 et TP3 identiques. Le courant $i_{réf}$ est alors égal à $V_R / R_{réf}$. Il peut avantageusement être sensiblement insensible comme expliqué précédemment. Comme bien connu de l'homme de l'art, il est possible d'obtenir un courant $i_{réf}$ multiple du courant circulant dans les branches B1/B2 en prévoyant des tailles de transistors différentes entre d'une part le transistor TP3 et d'autre part les transistors TP1/TP2. Si on souhaite avoir un courant généré fixe, on pourra par exemple utiliser une tension de référence très stable en température notamment, par exemple délivré par un circuit de bandgap, pour polariser la grille arrière du transistor TN2 ou TN1. Les autres grilles arrière des autres transistors, et notamment celle de l'autre transistor TN1 ou TN2 du miroir nMOS, sont polarisées à une autre valeur de potentiel, avantageusement la masse ou $V_{DD}$. Le choix de la tension de polarisation est notamment fonction comme cela a été expliqué supra du type de transistors LVT ou RVT utilisés pour réaliser le circuit.

Le générateur ainsi formé peut générer de faibles valeurs de courant $i_{réf}$ tout en ayant une résistance de référence $R_{réf}$ de faible valeur, donc peu encombrante. En effet, si on compare le générateur de courant à celui de l'art antérieur illustré en figure 1bis, en utilisant une même tension de référence, on peut utiliser une résistance 5 à 10 fois plus faible que celle du circuit de l'art antérieur, grâce à la division de tension entre la tension de référence et la tension présente aux bornes de la résistance.

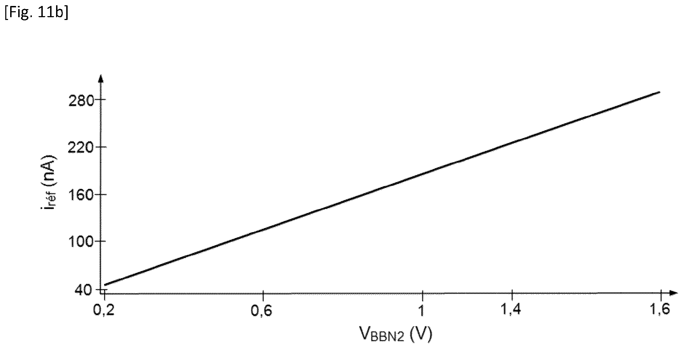

[Fig. 11a] et [Fig. 11b] présentent des résultats de simulations obtenus pour le générateur de courant de la figure 10.

Plus particulièrement, la figure 11a représente le courant $i_{réf}$ généré en fonction de la température. Celui-ci varie entre 220,8 nA et 221,2 nA pour une température entre - 40 °C et 150 °C. Ce générateur de courant est donc très stable en température.

La figure 11b représente le courant généré $i_{réf}$ en fonction du potentiel $V_{BBN2}$ de polarisation de la grille arrière du transistor TN2. On remarque que ces deux grandeurs sont proportionnelles, ce qui confirme le fait que le rapport entre $V_R$ et $V_{BBN2}$ est constant quelle que soit la valeur de $V_{BBN2}$. Donc que les transistors soient en fonctionnement de faible ou forte inversion, ce rapport reste stable.

De manière générale, on peut réaliser un système électronique comprenant un circuit électronique selon l'invention.

En outre, le terme circuit externe a été utilisé pour désigner un circuit électronique constitué de composants autres que ceux présents dans les deux branches B1 et B2 et nécessaire à la réalisation d'un circuit électronique diviseur de tension selon la présente invention. On notera néanmoins, que tous les circuits « externes » décrits précédemment ont en pratique vocation à être réalisés de préférence sur un même circuit intégré.

**Revendications**

1. Circuit électronique diviseur de tension comprenant au moins deux transistors sur couche mince isolante FDSOI (TP1, TP2) d'un premier type reliés à un premier potentiel d'alimentation et agencés en une structure de miroir de courant et deux transistors sur couche mince FDSOI (TN1, TN2) d'un second type et une charge électrique d'impédance non nulle (R), les transistors ayant chacun une grille principale en face avant ($G_{top}$) et une grille de réglage en face arrière ($G_{back}$), un drain d'un premier transistor (TN1) du second type étant relié au drain d'un premier transistor (TP1) du premier type, un drain d'un deuxième transistor (TN2) du second type étant relié au drain d'un deuxième transistor (TP2) du premier type, le drain du premier transistor du second type étant relié à la grille en face avant de ce même transistor, les grilles en face avant des premier et deuxième transistors du second type étant reliées entre elles, la source du premier transistor du second type étant reliée à un second potentiel d'alimentation et ladite charge d'impédance non nulle étant placée entre la source du second transistor du second type et ledit second potentiel d'alimentation, le drain du second transistor (TP2) du premier type étant connecté à la grille en face avant des premiers et second transistors (TP1, TP2) du premier type, dans lequel

   les grilles en face arrière des premier et deuxième transistors de second type (TN2) sont reliées à un circuit externe (CPGA) appliquant une tension d'entrée non nulle entre ces deux grilles en face arrière de telle sorte que la grille en face arrière du première transistor du second type soit amenée à un potentiel ($V_{BBN1}$) inférieur à celui ($V_{BBN2}$) de la grille face arrière du deuxième transistor du second type si ces deux transistors sont de type nMOS, et que la grille en face arrière du première transistor du second type soit amenée à un potentiel ($V_{BBP1}$) supérieur à celui ($V_{BBP2}$) de la grille face arrière du deuxième transistor du second type si ces deux transistors sont de type pMOS ;
   moyennant quoi la tension aux bornes de ladite charge ($V_R$) constitue une tension de sortie égale à la somme d'une première composante A et d'une seconde composante B ;
   la première composante A étant dépendante de la différence parmi les ratios géométriques largeur sur longueur de grille desdits transistors ; la seconde composante B étant proportionnelle à ladite tension d'entrée non nulle avec un facteur de proportionnalité strictement inférieur à 1 ; la seconde composante B étant prépondérante par rapport à la première composante A.

2. Circuit électronique selon la revendication 1 dans lequel les transistors de premier type sont des pMOS et les transistors de second type sont des nMOS, et dans lequel le potentiel ($V_{BBN2}$) appliqué sur la grille en face arrière du second transistor du second type est supérieur au potentiel ($V_{BBN1}$) appliqué sur la grille en face arrière du premier transistor du second type.

3. Circuit électronique selon la revendication 1 dans lequel les transistors de premier type sont des nMOS et les transistors de second type sont des pMOS et dans lequel le potentiel ($V_{BBN2}$) appliqué sur la grille en face arrière du second transistor du second type est inférieur au potentiel ($V_{BBN1}$) appliqué sur la grille en face arrière du premier transistor du second type.

4. Circuit électronique selon l'une des revendications précédentes dans lequel les transistors de second type sont des transistors à faible valeur de seuil LVT .

5. Circuit électronique selon l'une des revendications 1 à 3 dans lequel les transistors de second type sont des transistors à valeur de seuil standard RVT.

6. Circuit électronique selon l'une des revendications 1 à 5 dans lequel les transistors de second type sont identiques.

7. Circuit électronique selon l'une des revendications 1 à 5 dans lequel les transistors de second type sont différents, leurs ratios géométriques largeur sur longueur de grilles étant différents de 20% au plus.

8. Circuit électronique selon l'une des revendications 1 à 7 dans lequel la tension d'entrée entre les deux grilles en face arrière des premier (TN1) et deuxième (TN2) transistors de second type est suffisamment élevée pour que la seconde composante B soit supérieure, d'au moins un facteur 10, de la première composante A.

9. Système électronique comprenant un circuit électronique selon l'une des revendications précédentes dans lequel le circuit externe (CPGA) comprend un troisième transistor (TP6) du premier type dont la source est reliée au premier potentiel d'alimentation, la grille est reliée aux grilles des premier et deuxième transistors du premier type, et le drain est relié à un nœud relié à un circuit de charge.

10. Système électronique de type source de courant selon la revendication 9, dans lequel le circuit externe (CPGA) génère une tension de référence stable, par exemple fournie par un circuit bandgap ; ladite tension de référence stable est appliquée en tension d'entrée entre les grilles de face arrière des premier et deuxième transistors de second type.

11. Système électronique comprenant un circuit électronique selon la revendication 9 dans lequel le circuit externe (CPGA) comprend en outre un circuit de génération d'un signal d'horloge oscillant comprenant une pluralité d'inverseurs reliés entre eux de manière à former une boucle, une sortie d'un inverseur étant reliée à une entrée d'un autre inverseur et dans lequel ledit nœud est reliée d'une part à une borne d'alimentation en tension/courant de ladite pluralité d'inverseurs, et d'autre part à la grille en face arrière du deuxième transistor de second type.

12. Circuit électronique selon l'une des revendications 1 à 7 comprenant en outre au moins une paire cascode de transistors du premier type placés entre le miroir de courant et les transistors de second type.

13. Circuit électronique selon l'une des revendications 1 à 7, comprenant en outre au moins une paire cascode de transistors du second type placés entre les transistors du premier type et les transistors de second type.

**Patentansprüche**

1. Elektronische Spannungsteilerschaltung, umfassend mindestens zwei Transistoren auf einer isolierenden Dünnschicht FDSOI (TP1, TP2) eines ersten Typs, die mit einem ersten Versorgungspotential verbunden und in einer Stromspiegelstruktur angeordnet sind, und zwei Transistoren auf einer Dünnschicht FDSOI (TN1, TN2) eines zweiten Typs und eine elektrische Last mit einer Impedanz ungleich null (R), wobei die Transistoren jeweils ein frontseitiges Hauptgatter ($G_{top}$) und ein rückseitiges Regelgatter ($G_{back}$) aufweisen, ein Drain eines ersten Transistors (TN1) des zweiten Typs mit dem Drain eines ersten Transistors (TP1) des ersten Typs verbunden ist, ein Drain eines zweiten Transistors (TN2) des zweiten Typs mit dem Drain eines zweiten Transistors (TP2) des ersten Typs verbunden ist, der Drain des ersten Transistors des zweiten Typs mit dem frontseitigen Gatter desselben Transistors verbunden ist, die frontseitigen Gatter des ersten und des zweiten Transistors des zweiten Typs miteinander verbunden sind, die Source des ersten Transistors des zweiten Typs mit einem zweiten Versorgungspotential verbunden ist und die Last mit einer Impedanz ungleich null zwischen der Source des zweiten Transistors des zweiten Typs und dem zweiten Versorgungspotential platziert ist, der Drain des zweiten Transistors (TP2) des ersten Typs mit dem frontseitigen Gatter des ersten und des zweiten Transistors (TP1, TP2) des ersten Typs verbunden ist,

wobei die rückseitigen Gatter des ersten und des zweiten Transistors des zweiten Typs (TN2) mit einer externen Schaltung (CPGA) verbunden sind, die eine Eingangsspannung ungleich null zwischen diesen beiden rückseitigen Gattern dergestalt anlegt, dass das rückseitige Gatter des ersten Transistors des zweiten Typs auf ein Potenzial ($V_{BBN1}$) gebracht wird, das niedriger ist als das ($V_{BBN2}$) des rückseitigen Gatter des zweiten Transistors des zweiten Typs, wenn diese beiden Transistoren Transistoren vom nMOS-Typ sind, und dass das rückseitige Gatter des ersten Transistors des zweiten Typs auf ein Potential ($V_{BBP1}$) gebracht wird, das größer ist als das ($V_{BBP2}$) des rückseitigen Gatters des zweiten Transistors des zweiten Typs, wenn diese beiden Transistoren Transistoren vom pMOS-Typ sind;

wodurch die Spannung an den Anschlüssen der Last ($V_R$) eine Ausgangsspannung ist, die gleich der Summe einer ersten Komponente A und einer zweiten Komponente B ist;

wobei die erste Komponente A von der Differenz zwischen den geometrischen Verhältnissen von Gatterbreite zu Gatterlänge der Transistoren abhängt; wobei die zweite Komponente B proportional zu der Eingangsspannung ungleich null ist, mit einem Proportionalitätsfaktor, der strikt kleiner als 1 ist; wobei die zweite Komponente B in Bezug auf die erste Komponente A vorherrschend ist.

2. Elektronische Schaltung nach Anspruch 1, wobei die Transistoren des ersten Typs pMOS-Transistoren sind und die Transistoren des zweiten Typs nMOS-Transistoren sind, und wobei das an das rückseitige Gatter des zweiten Transistors des zweiten Typs angelegte Potential ($V_{BBN2}$) größer ist als das an das rückseitige Gatter des ersten Transistors des zweiten Typs angelegte Potential ($V_{BBN1}$).

3. Elektronische Schaltung nach Anspruch 1, wobei die Transistoren des ersten Typs nMOS-Transistoren sind und die Transistoren des zweiten Typs pMOS-Transistoren sind und wobei das an das rückseitige Gatter des zweiten Transistors des zweiten Typs angelegte Potential ($V_{BBN2}$) kleiner ist als das an das rückseitige Gatter des ersten Transistors des zweiten Typs angelegte Potential ($V_{BBN1}$).

4. Elektronische Schaltung nach einem der vorhergehenden Ansprüche, wobei die Transistoren des zweiten Typs Transistoren mit niedrigem Schwellenwert LVT sind.

5. Elektronische Schaltung nach einem der Ansprüche 1 bis 3, wobei die Transistoren des zweiten Typs Transistoren mit Standardschwellenwert RVT sind.

6. Elektronische Schaltung nach einem der Ansprüche 1 bis 5, wobei die Transistoren des zweiten Typs identisch sind.

7. Elektronische Schaltung nach einem der Ansprüche 1 bis 5, wobei die Transistoren des zweiten Typs unterschiedlich sind, wobei sich ihre geometrischen Verhältnisse von Gatterbreite zu Gatterlänge um höchstens 20 % unterscheiden.

8. Elektronische Schaltung nach einem der Ansprüche 1 bis 7, wobei die Eingangsspannung zwischen den beiden rückseitigen Gattern des ersten (TN1) und des zweiten (TN2) Transistors des zweiten Typs ausreichend hoch ist, damit die zweite Komponente B um mindestens einen Faktor 10 größer ist als die erste Komponente A.

9. Elektronisches System umfassend eine elektronische Schaltung nach einem der vorhergehenden Ansprüche, wobei die externe Schaltung (CPGA) einen dritten Transistor (TP6) des ersten Typs umfasst, dessen Source mit dem ersten Versorgungspotential verbunden ist, dessen Gatter mit den Gattern des ersten und des zweiten Transistors des ersten Typs verbunden ist, und dessen Drain mit einem Knoten verbunden ist, der mit einer Lastschaltung verbunden ist.

10. Elektronisches System vom Typ Stromquelle nach Anspruch 9, wobei die externe Schaltung (CPGA) eine stabile Referenzspannung erzeugt, die beispielsweise von einer Bandgap-Schaltung bereitgestellt wird; wobei die stabile Referenzspannung als Eingangsspannung zwischen den rückseitigen Gattern des ersten und des zweiten Transistors des zweiten Typs angelegt wird.

11. Elektronisches System umfassend eine elektronische Schaltung nach Anspruch 9, wobei die externe Schaltung (CPGA) ferner eine Schaltung zur Erzeugung eines oszillierenden Taktsignals umfasst, die eine Vielzahl von Wechselrichtern umfasst, die miteinander verbunden sind, um eine Schleife zu bilden, wobei ein Ausgang eines Wechselrichters mit einem Eingang eines anderen Wechselrichters verbunden ist und wobei der Knoten einerseits mit einem Spannungs-/Stromversorgungsanschluss der Vielzahl von Wechselrichtern und andererseits mit dem rückseitigen Gatter des zweiten Transistors des zweiten Typs verbunden ist.

**12.** Elektronische Schaltung nach einem der Ansprüche 1 bis 7, ferner umfassend mindestens ein Kaskodenpaar von Transistoren des ersten Typs, die zwischen dem Stromspiegel und den Transistoren des zweiten Typs platziert sind.

**13.** Elektronische Schaltung nach einem der Ansprüche 1 bis 7, die ferner mindestens ein Kaskodenpaar von Transistoren des zweiten Typs umfasst, die zwischen den Transistoren des ersten Typs und den Transistoren des zweiten Typs platziert sind.

## Claims

**1.** An electronic voltage divider circuit comprising at least two FDSOI transistors on insulating thin film (TP1, TP2) of a first type connected to a first supply potential and arranged in a current mirror structure and two FDSOI transistors on thin film (TN1, TN2) of a second type and an electrical load of non-zero impedance (R), the transistors each having a front-face main gate ($G_{top}$) and a back-face control gate ($G_{back}$), a drain of a first transistor (TN1) of the second type being connected to the drain of a first transistor (TP1) of the first type, a drain of a second transistor (TN2) of the second type being connected to the drain of a second transistor (TP2) of the first type, the drain of the first transistor of the second type being connected to the front-face gate of this same transistor, the front-face gates of the first and second transistors of the second type being connected to one another, the source of the first transistor of the second type being connected to a second supply potential and said load of non-zero impedance being placed between the source of the second transistor of the second type and said second supply potential, the drain of the second transistor (TP2) of the first type being connected to a front-face gate of the first and second transistors (TP1, TP2) of the first type,

wherein the back-face gates of the first and second transistors of the second type (TN2) are connected to an external circuit (CPGA) applying a non-zero input voltage between these two back-face gates, such that the back-face gate of the first transistor of the second type is brought to a potential ($V_{BBN1}$) lower than that ($V_{BBN2}$) of the back-face gate of the second transistor of the second type if these two transistors are of nMOS type, and that the back-face gate of the first transistor of the second type is brought to a potential ($V_{BBP1}$) greater than that ($V_{BBP2}$) of the back-face gate of the second transistor of the second type if these two transistors are of pMOS type;
whereby the voltage across the terminals of said load ($V_R$) is an output voltage equal to the sum of a first component A and a second component B;
the first component A being dependent on the difference between the geometric ratios of gate width to gate length of said transistors; the second component B being proportional to said non-zero input voltage with a proportionality factor strictly less than 1; the second component B being preponderant with respect to the first component A.

**2.** The electronic circuit according to claim 1, wherein the transistors of the first type are pMOS transistors and the transistors of the second type are nMOS transistors, and wherein the potential ($V_{BBN2}$) applied to the back-face gate of the second transistor of the second type is greater than the potential ($V_{BBN1}$) applied to the back-face gate of the first transistor of the second type.

**3.** The electronic circuit according to claim 1, wherein the transistors of the first type are nMOS transistors and the transistors of the second type are pMOS transistors, and wherein the potential ($V_{BBN2}$) applied to the back-face gate of the second transistor of the second type is less than the potential ($V_{BBN1}$) applied to the back-face gate of the first transistor of the second type.

**4.** The electronic circuit according to one of the preceding claims, wherein the transistors of the second type are transistors with a low threshold value LVT.

**5.** The electronic circuit according to one of claims 1 to 3, wherein the transistors of the second type are transistors with a standard threshold value RVT.

**6.** The electronic circuit according to one of claims 1 to 5, wherein the transistors of the second type are identical.

**7.** The electronic circuit according to one of claims 1 to 5, wherein the transistors of the second type are different, their geometrical ratios of gate width to gate length being different by at most 20%.

**8.** The electronic circuit according to one of claims 1 to 7, wherein the input voltage between the two back-face gates of the first (TN1) and second (TN2) transistors of the second type is sufficiently high for the second component B to be greater, by at least a factor of 10, than the first component A.

9. The electronic system comprising an electronic circuit according to one of the preceding claims, wherein the external circuit (CPGA) comprises a third transistor (TP6) of the first type, whose source is connected to the first supply potential, whose gate is connected to the gates of the first and second transistors of the first type, and whose drain is connected to a node connected to a load circuit.

10. The current source type electronic system according to claim 9, wherein the external circuit (CPGA) generates a stable reference voltage, for example supplied by a bandgap circuit; said stable reference voltage is applied as input voltage between the back-face gates of the first and second transistors of the second type.

11. The electronic system comprising an electronic circuit according to claim 9, wherein the external circuit (CPGA) further comprises a circuit for generating an oscillating clock signal, comprising a plurality of inverters connected to one another so as to form a loop, an output of one inverter being connected to an input of another inverter and wherein said node is connected on the one hand to a voltage/current supply terminal of said plurality of inverters, and on the other hand to the back-face gate of the second transistor of the second type.

12. The electronic circuit according to one of claims 1 to 7, further comprising at least one cascode pair of transistors of the first type placed between the current mirror and the transistors of the second type.

13. The electronic circuit according to one of claims 1 to 7, further comprising at least one cascode pair of transistors of the second type placed between the transistors of the first type and the transistors of the second type.

[Fig. 1A]

[Fig. 1B]

[Fig. 2]

[Fig. 3]

[Fig. 4]

[Fig. 5]

[Fig. 6]

[Fig. 7]

[Fig. 8]

[Fig. 9]

$V_{DD}$

CPGA

$V_{DD}$

$R_{réf}$

$I_1$   $I_2$   $I_3$

$\Rightarrow f$

TP1

$V_{BBP1\_fixe}$

TP2

$V_{RO}$

TP3    TP4

TN3    TN4    TN6

i    i    i

TN1    TN2    TN5

B1    B2    B3

[Fig. 10]

[Fig. 11a]

[Fig. 11b]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016352339 A1
- EP 2415079 A